(19) Europäisches Patentamt
European Patent Office
Office européen des brevets

(11) **EP 3 382 362 A1**

(12) **EUROPEAN PATENT APPLICATION**

(43) Date of publication:
**03.10.2018 Bulletin 2018/40**

(51) Int Cl.:
***G01L 9/00*** (2006.01)

(21) Application number: **18166696.7**

(22) Date of filing: **09.06.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **14.07.2015 GB 201512288**

(62) Document number(s) of the earlier application(s) in accordance with Art. 76 EPC:
**16173621.0 / 3 118 599**

(71) Applicant: **Melexis Technologies NV**
**3980 Tessenderlo (BE)**

(72) Inventor: **VAN DER WIEL, Appolonius Jacobus**
**3080 Duisburg (BE)**

(74) Representative: **DenK iP**
**Leuvensesteenweg 203**
**3190 Boortmeerbeek (BE)**

Remarks:
This application was filed on 10-04-2018 as a divisional application to the application mentioned under INID code 62.

(54) **PRESSURE SENSOR WITH BUILT IN STRESS BUFFER**

(57) A semiconductor pressure sensor (1) comprising: a semiconductor substrate (2) having a through-opening (3) extending from a top surface (4) to a bottom surface (5) of the substrate (2), the through-opening (3) forming a space between an inner part (12) and an outer part (11) of said substrate; a pressure responsive structure arranged on said inner part (12); a number of flexible elements (7, 13) extending from said inner part (12) to said outer part (11) for suspending the inner part (12) within said through-opening (3); the through-opening being sealed with an anelastic material.

A method of producing such a semiconductor pressure sensor.

FIG 3

## Description

### Field of the invention

The invention relates to the field of pressure sensors, in particular semiconductor pressure sensors with a stress relief mechanism.

### Background of the invention

Semiconductor pressure sensors are known in the art. Such pressure sensors have a pressure sensitive element arranged to measure an absolute pressure (e.g. of a gas or liquid) or a relative pressure (e.g. the difference between two fluid pressures).

A problem with many pressure sensors is that the sensor measures (or outputs, or gives) a signal, even in the absence of a pressure (or pressure difference) to be measured. This offset may e.g. be the result of mechanical stress and/or deformation of the housing (e.g. packaging) of the sensor. The housing-stress/deformation will typically also cause a stress-component at the sensor surface where the sensitive elements (e.g. piezo-resistors) are located, and thereby cause an offset error, a linearity error or even a hysteresis error to the output signal.

A constant offset-error can be compensated by calibration, but in practice the stress and/or deformation of the housing is dependent a.o. on temperature and humidity changes in the environment, and may in extreme cases even result in plastic deformation of certain housing materials. Temperature compensation can be used to reduce or cancel the errors due to reversible deformation of the housing, but it cannot compensate errors due to irreversible plastic deformation. Such errors are often referred to as 'long term drift' or 'drift over life'.

About 20 years ago this problem was addressed by providing grooves from the front and from the back (of the semiconductor substrate) using anisotropic etching to obtain a spring between the membrane area and the bonding area. However, these solutions require a relatively large semiconductor area and cannot withstand very well radial stress (e.g. due to thermal compression or expansion of the housing).

### Summary of the invention

It is an object of embodiments of the present invention to provide a good pressure sensor, and a method for making same.

It is an object of embodiments of the present invention to provide a pressure sensor that is less sensitive to packaging stress and/or stress caused by temperature and/or by humidity changes, and a method for making same.

It is an object of embodiments of the present invention to provide a pressure sensor with a good stress relief mechanism, and a method for making same.

It is an object of embodiment of the present invention to provide a pressure sensor with a reduced sensitivity to radial stress and torque, and a method for making same.

These objectives are accomplished by a method and device according to embodiments of the present invention.

In one aspect, the present invention relates to a semiconductor pressure sensor for measuring a pressure, comprising:a semiconductor substrate having a through-opening extending from a top surface to a bottom surface of the substrate, the through-opening forming a hollow space between an inner part and an outer part of said substrate;

a pressure responsive structure arranged on said inner part;

a number of flexible elements extending from said inner part to said outer part for suspending the inner part within said through-opening;

the through-opening being sealed with an anelastic material.

The pressure responsive structure may comprise a membrane arranged for deforming under the pressure to be measured, and one or more elements for allowing measurement of said deformation; and optionally wherein the one or more elements are piezo-resistive elements.

The through-opening may be or may comprise a groove extending in a direction perpendicular to the substrate. Optionally the through-opening may have a circular cross section in a plane parallel to the substrate.

The flexible elements may be beams. Optionally the beams may have a length (Lb) and a width (Wb) and a height (Hb), whereby the height (Hb) is at least 2.0 times the width (Wb). Optionally the beams may extend across the through-opening in a non-radial direction (X). Optionally the beams may be tangential to a circumference of the inner part;

Optionally the beams may be parallel to the substrate and wherein a thickness (Tm) of the membrane and a thickness (Tb) of beam are substantially the same..

Optionally the number of beams may be a value in the range from 3 to 32, preferably in the range from 3 to 4.

The flexible elements may be formed by applying a metallization that extends accross the through-opening on top of the anelastic material.

Sealing may be at least partially filling of the through-opening.

The present invention also relates to a method of producing a semiconductor pressure sensor, comprising the steps of:

a) providing a substrate;

b) making a through-opening extending from a top surface to a bottom surface of said substrate along a closed curve, said through-opening forming a hollow space between an inner part and an outer part of said substrate;

b) forming a pressure responsive structure on said inner part;

c) sealing the through-opening with an anelastic material;

d) providing a number of flexible elements extending from said inner part to said outer part for suspending the inner part within said through-opening.

The step of forming a pressure responsive structure on said inner part may comprise forming a membrane and forming pressure sensitive elements located at least partly on the membrane. Optionally forming the pressure sensitive elements may comprise forming piezo-resistive elements. Optionally forming a through-opening may comprise forming a groove extending in a direction perpendicular to the substrate.

Optionally the step of making a through-opening may comprise making an annular opening.

The step of providing flexible elements may comprise forming flexible beams extending from the inner part to the outer part.

Optionally the flexible beams may be formed in such a way that the beams are straight and extend in a non-radial direction.

Optionally the flexible beams may be formed in such a way that the beams are tangential to a circumference of the inner part.

The beams and the membrane may be formed such that the beams are parallel to the substrate and such that a thickness (Hm) of the membrane and a thickness (Hb) of the beams is substantially the same. The step of providing flexible elements may comprise applying a metallization directly on top of the anelastic material.

The method may further comprise a step of grinding the substrate and the step of sealing the through-opening with an anelastic material occurs either before the step of grinding the substrate and before the step of metallization or before the step of grinding the substrate but after the step of metallization. The method may further comprise a step of grinding the substrate, and the step of sealing the through-opening with an anelastic material may occur after the step of grinding the substrate.

The method may further comprise a step of simultaneously back etching the outer part and the inner part, wherein the step of sealing the through-opening with an anelastic material may occur before the step of metallization.

The method may further comprise a step of simultaneously back etching the outer part and the inner part, and the step of sealing the through-opening with an anelastic material may occur before the step of back etching but after the step of metallization.

The method may further comprise a step of back etching the inner part but not the outer part, and the step of sealing the through-opening with an anelastic material may occur before the step of metallization.

The method may further comprise a step of back etching the inner part (12) but not the outer part, and the step of sealing the through-opening with an anelastic material may occur before the step of back etching but after the step of metallization.

The method may further comprise a step of simultaneously back etching the the outer part and the inner part, and wherein the step of sealing the through-opening with an anelastic material may occur after the step of back etching.

The method may further comprise a step of back etching the inner part but not the outer part and the step of sealing the through-opening with an anelastic material may occur after the step of back etching. In another aspect, the present invention provides a semiconductor pressure sensor comprising: a semiconductor substrate having a through-opening extending from a top surface to a bottom surface of the substrate, the through-opening forming a hollow space between an inner part and an outer part of said substrate; a pressure responsive structure arranged on said inner part; a number of flexible elements extending from said inner part to said outer part for suspending the inner part within said through-opening; the through-opening being at least partly filled with an anelastic material such that where the anelastic material prevents the fluid flowing from one side to the other side of the sensor

It is an advantage of embodiments according to the present invention that the pressure responsive structure is arranged on the inner part within the through-opening, and suspended by flexible elements, acting as spring elements, which mechanically isolates the inner structure from the rest of the substrate, so that stress exerted on the substrate, in particular on the outer part, does not extend (or only to a limited amount) into the pressure responsive inner structure.

It is an advantage of embodiments of the present invention that the inner part is arranged in said through-opening, and is only suspended by a number of flexible elements, because such suspension allows slight movement, e.g. rotation of the inner part (with the pressure responsive structure) relative to the outer part, which alleviates stress, and only allows a minimum amount of stress induced by the housing.

It is an advantage of embodiments of the present invention wherein the flexible elements are the only mechanical link between the inner part (comprising the pressure responsive structure) and the rest of the substrate, in particular the outer part (in contrast to stiff connections), because it reduces or eliminates the the stress changes caused byf irreversible plastic deformation on the outer part to be transferred to the inner part, which otherwise would be leading to errors often referred to as "long term drift" or "drift over life".

It is an advantage of embodiments of the present invention that the inner part (with the pressure responsive structure) does not move up and down (e.g. in a direction perpendicular to the substrate plane) when stress is exerted on the surrounding body, (i.e. the outer part) but merely rotates the inner part (comprising the pressure responsive structure) in a plane parallel to the substrate, hence the pressure responsive structure stays at the same height within the package.

Typically an opening (distance) is left between the outer (e.g. cylindrical) surface or wall of the inner part and an inner (e.g. cylindrical) surface or wall of the outer part, apart from the flexible elements (acting as spring elements), which allows thermal expansion or compression of the inner part without causing (significant) stress to the inner and outer part (only to the flexible elements). In this way stress in the substrate or stress of the housing, e.g. caused by packaging due to temperature or humidity changes, can be substantially decoupled from stress in the inner part, in particular in the pressure responsive structure located thereon, and offset errors and/or linearity errors, and/or hysteresis errors can be reduced. In other words, this stress relief mechanism isolates the membrane from packaging stress exerted upon the substrate.

It is an advantage that the above described stress relief mechanism makes the inner structure insensitive to uniform stress, can absorb (or at least largely reduce) radial stress (e.g. due to compression or expansion of the outer part), and torque.

The anelastic material functions as a sealing to prevent a fluid flow through the through-opening, from one side of the sensor to the other side, although in most cases the sealing does not need to be hermetic.

It is an advantage of providing a flexible mechanical link between the pressure responsive structure and the housing whereto the outer part is typically mounted, in that it minimizes the drift or the risk of drift over the product lifetime and allows better error compensation by calibration and/or temperature compensation.

In an embodiment, the pressure responsive structure comprises a membrane arranged for deforming under the pressure to be measured, and one or more elements for allowing measurement of said deformation.

Membranes and diaphragms are well known in the field of pressure sensors, and typically have a reduced thickness as compared to their direct environment in order to increase their sensitivity. According to aspects of the present invention, pressure sensing elements are located on the membrane, preferably near a membrane edge, and not near the flexible elements, so as to measure deformation of the membrane due to pressure exerted thereon, rather than stress exerted by the package on the pressure responsive structure.

In an embodiment, the one or more elements are piezo-resistive elements.

Pressure measurements using piezo-resistive elements, and readout circuitry for obtaining a value therefrom, such as e.g. a Wheatstone bridge, are well known in the art, and hence need not be explained further here.

In an embodiment, the through-opening is or comprises a groove extending in a direction perpendicular to the substrate.

It is an advantage of the groove extending in a direction perpendicular to the substrate (e.g. "vertical groove") that this stress-relief mechanism requires less space than other prior art solutions, e.g. using spring-like or harmonica-like or zig-zag or serpentine-like structures, which also extend in a direction parallel to the substrate. Hence such a pressure sensor can be made more compact. Such a groove can be conveniently produced using anisotropic etching techniques. Especially deep reactive ion etching allows making narrow and deep grooves, but other etching techniques can also be used.

In an embodiment, the through-opening has a circular cross section in a plane parallel to the substrate.

Such an opening is ideally suited for receiving a cylindrical pressure responsive structure with a circular membrane. Apart from the flexible elements, such an opening would have an annular shape. But the invention is not restricted to this particular shape and openings having other shapes can also be used.

In an embodiment, the flexible elements are beams.

The beams may be silicon beams. By choosing proper dimensions, e.g. length, height and width, the beams can be designed to have a predefined strength to support the inner part, while having sufficient flexibility in order to reduce, e.g. minimize the stress induced by the housing. In particular embodiments, the silicon may be left out by filling the slits with the anelastic material before metallization.

The flexible elements, the inner part and the outer part may be integrally formed (also known as "monolithic"), meaning that they may be formed from a single piece of substrate material where the opening is formed by removing material. This offers the advantage that the mechanical connection of the flexible elements can be very strong, in particular can be stronger than beams formed by additive techniques.

The beams may have the same thickness (height) as the membrane. Alternatively, the beams can be made thinner or thicker than the membrane .

In an embodiment, the beams have a length and a width and a height, whereby the height is at least 2.0 times the width.

In an embodiment, the beams extend across the through-opening in a non-radial direction.

By orienting the beams in a non-radial direction, stress in the substrate e.g. due to thermal expansion, may cause lateral movement of an anchor point of the beam on the substrate side, and may cause bending of the beam, but can translate in rotation of the pressure responsive structure, thereby absorbing the lateral stress without passing it to the membrane. In this way a more accurate measurement of the pressure can be performed.

The beams may be straight beams. It is an advantage of using straight beams rather e.g. a Serpentine shape, in that it is mechanically more stable, while being easily bendable in a direction perpendicular to its longitudinal direction.

In an embodiment, the beams are tangential to a circumference of the inner part.

By choosing a tangential arrangement, lateral displacement of an anchor point of the beam causes maximum rotation of the inner part and thus maximum absorption of lateral strain.

In an embodiment, the beams are parallel to the substrate and a thickness of the membrane and a thickness of beam are substantially the same.

With substantially the same is meant "within a tolerance margin of +/-10%". Typically so-called horizontal beams may be used. By choosing the same thickness of the membrane, the beams and the membrane may be formed in the same step. it is an advantage if the upper side of the beam and of the membrane are substantially level, because it allows electrical connections from the membrane, e.g. from the piezo-resistors, to be routed over the beams towards circuitry on the substrate.

In an embodiment, the number of beams is a value in the range from 3 to 32, preferably in the range from 3 to 4.

In a particular embodiment only three suspension locations are used. This offers the advantage over a suspension having only two beams that a more stable mechanical link is obtained, and that the risk of rotation of the pressure responsive structure around the two beams is eliminated, and that the risk of fracture of the beams is reduced.

The number of beams may be chosen equal to the number of pressure sensing elements, so that each interconnection can be routed over one corresponding beam, but it is also possible to route multiple interconnections over a single beam, or having beams with no electrical interconnection, only mechanical.

Other embodiments of the present invention may have more than four beams for suspending the pressure responsive structure.

If backgrinding is used to create the through-opening, the number of beams and/or the flexibility of the beams may be chosen taking into account the strength required for backgrinding.

In an embodiment, the flexible elements are formed by applying a metallization that extends accross the through-opening on top of the anelastic material.

It is an advantage of using metal interconnect rather than silicon beams, because it can make the connection between the inner and outer part more flexible.

In a second aspect, the present invention provides a method of producing a semiconductor pressure sensor, comprising the steps of: a) providing a substrate; b) making a through-opening extending from a top surface to a bottom surface of said substrate so as to form a hollow space between an inner part and an outer part of said substrate; b) forming a pressure responsive structure on said inner part; c) at least partly filling the through-opening with an anelastic material or a gel; d) providing a number of flexible elements extending from said inner part to said outer part for suspending the inner part within said through-opening.

In an embodiment, the step of forming a pressure responsive structure on said inner part comprises forming a membrane and forming pressure sensitive elements located at least partly on the membrane.

In an embodiment, forming the pressure sensitive elements comprises forming piezo-resistive elements.

In an embodiment, the step of forming a through-opening comprises forming a groove extending in a direction perpendicular to the substrate.

In an embodiment, the step of making a through-opening comprises making an annular opening, thus creating a cylindrical inner part.

In an embodiment, the step of providing flexible elements comprises forming flexible beams extending from the inner part to the outer part.

In an embodiment, the flexible beams are formed in such a way that the beams are straight and extend in a non-radial direction.

In an embodiment, the flexible beams are formed in such a way that the beams are tangential to a circumference of the inner part.

In an embodiment, the beams and the membrane are formed such that the beams are parallel to the substrate and such that a thickness of the membrane and a thickness of the beams is substantially the same.

In an embodiment, the step of providing flexible elements comprises applying a metallization directly on top of the anelastic material.

In an embodiment, the method further comprises a step of grinding the substrate, the step of at least partly filling the through-opening with an anelastic material occurs before the step of grinding the substrate and before the step of metallization.

In an embodiment, the method further comprises a step of grinding the substrate, and the step of at least partly filling the through-opening with an anelastic material occurs before the step of grinding the substrate but after the step of metallization.

In an embodiment, the method further comprises a step of grinding the substrate, and the step of at least partly filling the through-opening with an anelastic material occurs after the step of grinding the substrate.

In an embodiment, the method further comprises a step of simultaneously back etching the outer part and the inner part, and the step of at least partly filling the through-opening with an anelastic material occurs before the step of metallization.

In an embodiment, the method further comprises a step of simultaneously back etching the the outer part and the inner part, and the step of at least partly filling the through-opening with an anelastic material occurs before the step of back etching but after the step of metallization.

In an embodiment, the method further comprises a step of simultaneously back etching the the outer part and the inner part, and the step of at least partly filling the through-opening with an anelastic material occurs after the step of back etching.

Using back etching instead of grinding has the advantage that the risk of breaking the flexible elements (e.g. the beams) is drastically reduced or even eliminated.

In an embodiment, the method further comprises a step of back etching the inner part but not the outer part, and the step of at least partly filling the through-opening with an anelastic material occurs before the step of metallization.

In an embodiment, the method further comprises a step of back etching the inner part but not the outer part, and the step of at least partly filling the through-opening with an anelastic material occurs before the step of back etching but after the step of metallization.

In an embodiment, the method further comprises a step of back etching the inner part but not the outer part, and the step of at least partly filling the through-opening with an anelastic material occurs after the step of back etching.

By only back etching the inner part, or by back-etching the inner part longer than the outer part, the outer part can be thicker and stiffer than the inner part, which facilitates packaging and reduces the package stress on the beams

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

FIG. 1 shows a pressure sensor with a V-groove flexible connection, known in the art.

FIG. 2 shows an embodiment of a pressure sensor according to the present invention. The dotted lines between FIG. 1 and FIG. 2 show the advantage of size-reduction offered by embodiments according to the present invention, while the membrane size and the width of the bonding area can be kept the same.

FIG. 3 shows an embodiment of a pressure sensor according to the present invention, with an outer part having a "substantially annular" opening wherein a "substantially cylindrical" inner body is located, suspended by means of "beams", the inner bodycomprising a membrane and a plurality of pressure sensitive elements. FIG. 3(a) shows a kind of cross sectional view, and FIG. 3(b) shows a top view.

FIG. 4 shows a process flow for manufacturing the flexible structure of FIG. 3 and for filling the opening at wafer level.

FIG. 5 is a schematic illustration of an embodiment of the present invention, subjected to radial stress.

FIG. 6 is a schematic illustration of an embodiment of the present invention, subjected to uniform stress.

FIG. 7 is a schematic illustration of an embodiment of the present invention, subjected to torque stress.

FIG. 8 shows a schematic illustration of an examplary embodiment of the present invention with a differential capacitive mechanism for pressure sensing

FIG. 9 shows a schematic cross section of the mounting of an examplary embodiment of the present invention in a conventional QFN package

FIG. 10 shows a schematic cross section of the mounting of an exemplary embodiment of the present invention in a conventional SOIC package

FIG. 11 shows a schematic cross section of the examplary embodiment of FIG. 3(a) with solder bumps.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in the present invention reference is made to "stress", what is meant is "mechanical stress", unless explicitly stated otherwise.

In this document, the terms "flexible elements" and "bridges" are used as synonyms, and "beams" is a particular example thereof.

Where in the present invention reference is made to "substantially annular opening", what is meant is an opening which has a mainly annular shape, apart from one or more elements, extending across said opening.

Where in the present invention reference is made to "substantially cylindrical body", what is meant is a body having mainly a cylindrical outer surface, apart from one or more elements extending from the outer surface.

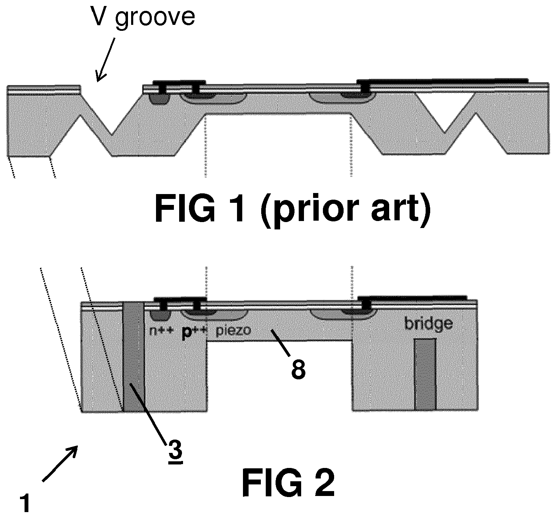

**FIG. 1** shows a prior art device with a V-groove flexible connection. The V-groove creates a spring type structure, and can be created with anisotropic etching (simultaneously) from the front and from the back of the substrate, e.g.

semiconductor substrate. Such a structure has several disadvantages: (1) the structure can absorb radial stress, but cannot absorb non-radial stress or torque, (2) the silicon area required for implementing the spring-like V-groove is relatively large, (3) the sensing area will vertically move in function of the direction of the stress experienced by the substrate surrounding the sensing area, (4) the structure does not allow easy routing of electrical paths for readout of the sensing elements.

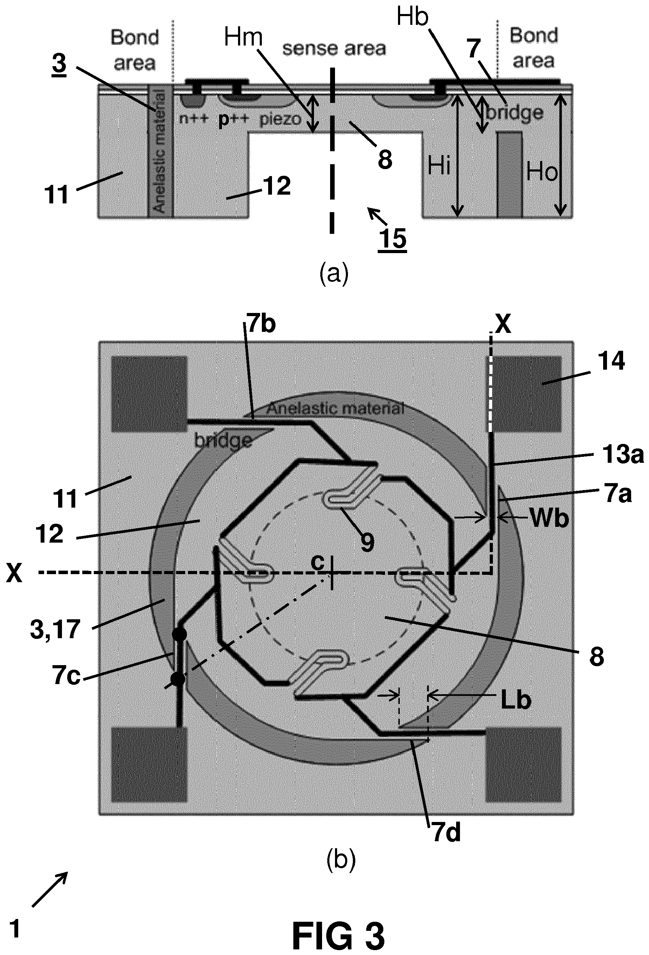

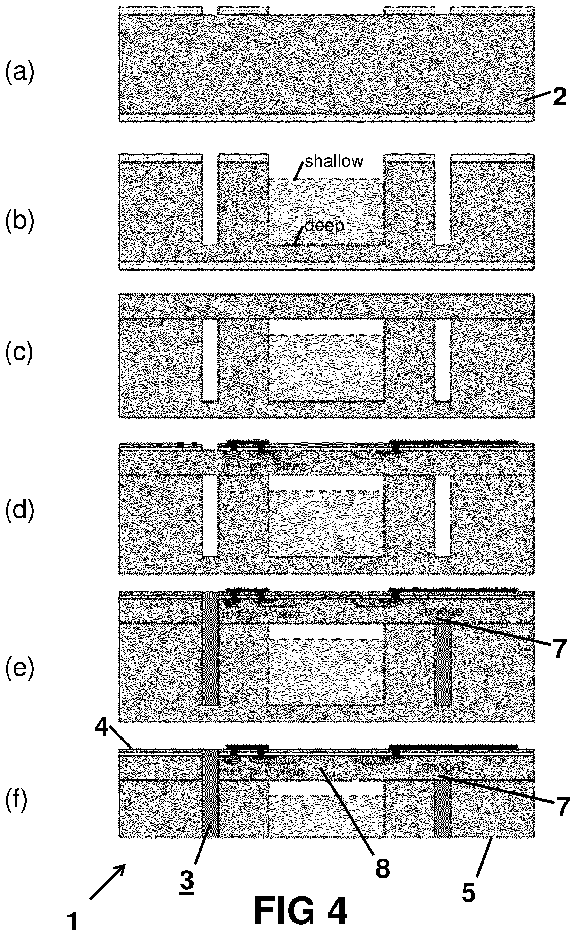

**FIG. 2** shows an embodiment of a pressure sensor (or part thereof) according to the present invention, having substantially the same pressure sensitive structure (further referred to as "inner body") as was used in FIG. 1, but having another mounting mechanism, which will be explained in more detail in FIG. 3 and FIG. 4. The dotted lines between FIG. 1 and FIG. 2 show the reduced silicon size obtainable by embodiments according to the present invention. Of course, this reduction is only shown for one particular embodiment, but the present invention is not limited to only the pressure sensitive structure that was used in FIG. 1, and other pressure sensitive structures may also be used. The purpose of FIG. 2 is merely to illustrate the reduced size, as one advantage of embodiments of the present invention.

**FIG. 3** shows a particular embodiment of a pressure sensor 1 according to the present invention in more detail. The sensor 1 preferably has a monolithic shape, which (for the sake of explanation) can be seen as being composed of several parts:

- an outer part 11, in the example having a square cross section in a horizontal plane. The outer part 11 has a through-opening, in the example a substantially cylindrical opening extending over its entire height;
- an inner part 12, also referred to herein as "inner body", in the example a cylindrical body, having an outer diameter smaller than the inner diameter of the opening of the outer part 11, so as to create an annular space between the outer part 11 and the inner part 12 for allowing the inner part 12 to move. The inner part 12 further comprises a cylindrical cavity 15 (see FIG. 3(a) on its bottom side, and a membrane 8 on its upper side;
- a number of flexible connections, in the example four beams (also referred to as "bridges") 7a to 7d, extending from the outer part 11 to the inner part 12, and forming a mechanical connection between the inner part 12 and the outer part 11;
- the annular opening 3 between the inner part 12 and the outer part 11 is at least partly, preferably completely filled with an anelastic material 17, to prevent a fluid flow through the opening, e.g. a gas or liquid. This works like a kind of sealing, but the sealing need not to be hermetic. The advantage of using an anelastic material such as e.g. polyimide is that for such materials the deflection increases more than linearly with the applied stress. That means that one can consider that such material gets softer when it gets more displaced. stretched. Normally materials have a constant stiffness when they are stretched until they break (e.g. silicon).

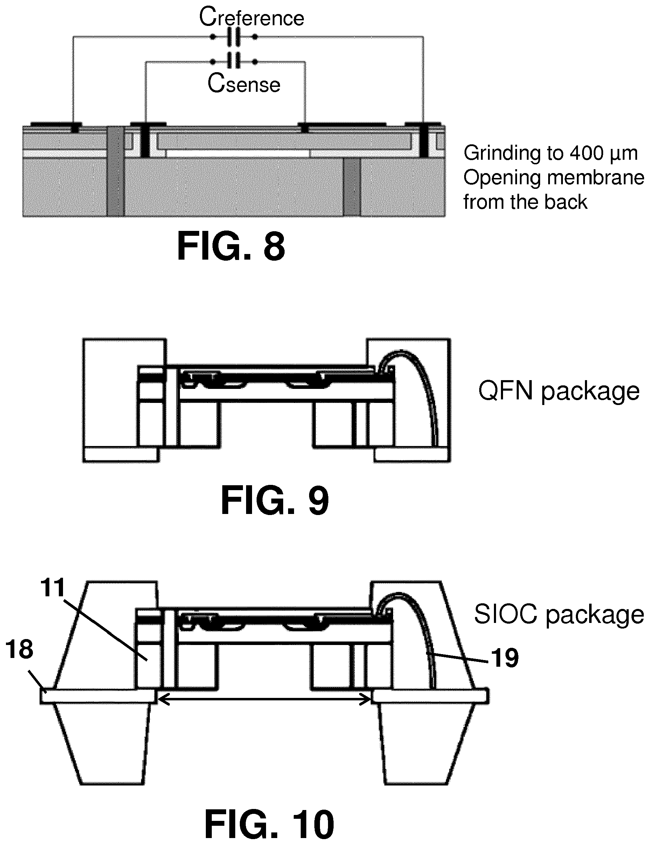

The outer part 11 is relatively stiff, and is typically mounted in a housing (not shown in figure 3), and may comprise bonding pads 14 for bumping or wire bonding (see for example FIG. 9 or FIG. 10, but other packages can also be used).

The inner part 12 comprises a pressure responsive structure, also known as pressure transducer, to convert pressure into an electrical signal. Several pressure responsive structures can be used, and the working of such structures is well known in the art, and therefore need not be explained in further detail here. It suffices to say that such a structure typically comprises a membrane 8, in the example shown: a circular membrane, and comprises a plurality of pressure sensitive elements 9, in the example: four piezo-resistive elements 9. When a pressure is applied to the membrane surface, said surface slightly (elastically) deforms, and the values of the electrical resistance of the piezo-resistors 9 arranged thereon will also change (e.g. linearly with the pressure applied). This resistance change can be measured by readout circuitry (known in the art), and the value is indicative for the mechanical pressure exerted on the membrane, which is the pressure to be measured. The resistance changes may be readout for example by a Wheatstone bridge circuit. Thereto, the piezo-resistors 9 are connected by means of electrical connections 13, which are routed (in this example) to bond pads 14, from where they can be connected to readout circuitry located outside of the membrane 8. The bond pads 14 can be used to apply biasing voltages, e.g. VDD and GND, and for reading out a differential signal Vout-, Vout+ in ways well-known in the art.

An important aspect of the present invention is how the inner part 12 is mechanically linked to the outer part 11. According to the present invention the inner part 12 is arranged in the through-opening 3 of the outer part 11, and mounted thereto by means of a plurality of flexible elements 7. In the example shown in FIG. 3, the flexible elements 7 are four silicon beams extending across the opening 3 between the inner part 12 and the outer part 11. The beams 7 shown in FIG. 3 are straight elongated beams, and are bendable in a direction perpendicular to their longitudinal direction, and are oriented tangentially to the circumference of the cylindrical inner part 12. It is an advantage that the beams are oriented in a non-radial way (with respect to the center "c" of the inner part 12) because by doing so, stress exerted by the outer part 11 upon the beams 7 is at least partly absorbed by the beams 7, rather than being simply transmitted to the inner part 12. Furthermore, uniform stress, radial stress and torque exerted by the outer part on the beams, will result in an elastic deformation of the flexible beams 7 and a rotation of the inner part 12, so that most of the stress is absorbed by the beams. The result is that the stress exerted on the inner part 12 is only a fraction of the stress exerted on the beams, so that deformation of the membrane due to package stress or stress due to temperature changes and humidity changes of the outer structure is reduced, e.g. minimized.

FIG. 3(a) shows a kind of cross sectional view according to the line X-X of FIG. 3(b), whereby the left part of FIG. 3(a) shows the opening 3 between the inner part 12 and the outer part 11, extending from the top to the bottom of the outer part. In the example shown the height "Hi" of the inner part 12 and the height "Ho" of the outer part 11 are the same, but that is not absolutely required. As can be seen from FIG. 3(a) and FIG. 3(b) most of the opening 3 is left unconnected, apart from the four beams 7, which preferably do not extend over the entire height of the inner part 12, but only over "Hb" which is only a fraction of the height "Ho". The right part of FIG. 3(a) is not a real cross-sectional view, but is somewhat compressed, and illustrates the connection between the inner part 12 and the outer part 11 via the beam 7a. In the example shown the height "Hb" of the bridge 7 is the same as the height "Hm" of the membrane 8, which is convenient to produce (as will be explained further).

In alternative embodiments (not shown), the outer part 11 need not have a square outer cross-section (in a plane parallel to the substrate) but may be any substrate with a through-opening 3 in a direction perpendicular to the substrate.

Although a cylindrical opening 3 is preferred, because it provides a maximum slit volume with the smallest perimeter compared to the diameter of the membrane, this is not essential for the present invention, and other openings, for example an opening with a square shape or hexagonal shape or any other shape, may also be used. What is important is that the inner part 12 (or inner body with the one or more pressure sensitive elements) fits within the opening 3 of the outer part 11, and is movable therein, in particular, is slightly rotatable therein.

In the embodiment shown in FIG. 3(a) the outer part 11 has substantially the same height "Ho" as the (maximum) height "Hi" of the inner part 12, but that is not absolutely required, and the height "Ho" of the outer part 11 and the height "Hi" of the inner part 12 may also be different. As can be seen, the height "Hi" of the inner part 12 does not have to be constant.

In the embodiment shown in FIG. 3(a), the upper surface of the membrane 8 and the upper surface of the beam 7 are level, which offers the advantage that electrical connections (e.g. deposited metal tracks) can be easily routed from the inner part 12 to the outer part 11 over one or more of the beams 7.

The height "Hb" of the beams 7 may be the same as the height "Hm" of the membrane 8, but this is not absolutely required and they may be chosen independently. The dimensions of the membrane 8 (e.g. diameter, height) are typically selected for good sensitivity of the pressure measurement, while the dimensions of the beams 7 (e.g. length, width, height) and their orientation are typically chosen for sufficient mechanical strength while at the same time providing sufficient flexibility without breaking.

Suitable dimensions (height Hb, width Wb, length Lb) of the beams and a suitable orientation (e.g. angle to outer circumference) can be chosen the skilled person, for providing beams that are sufficiently strong for suspending the inner body 12, while being sufficiently flexible for reducing mechanical stress.

In the example shown, all the beams 7 have the same length "Lb" and the same height "Hb" and the same width "Wb", however this is not absolutely required for the present invention, and they may also have different heights, widths, and/or lengths, for example beams carrying multiple electrical connections may be wider, and beams without electrical connections may be narrower.

Although four beams 7 are shown in the embodiments described above, the number of beams need not be four, but may also be only three, or more than four. What is important however is that they are sufficiently flexible so that they can absorb at least part of the radial stress exerted by the outer body to the inner body. This can for example be achieved by providing relatively long and relatively thin beams, expressed mathematically as follows:

$$Lb > 4x\ Wb,\ and\ Hb > 1x\ Wb$$

The beams shown in FIG. 3 are straight beams, but that is not absolutely required, as long as the anchor points (indicated by black dots in the drawings) of the beams 7 on the inner part 12 and on the outer part 11 are not located in radial direction with respect to the mass centre (or gravity centre) of the inner part 12, because otherwise radial stress would be transmitted without attenuation to the inner part. Preferably the beams 7 are oriented so as to be tangential to an outer surface of the inner part 12, but that is not absolutely required, and other orientations between the tangential direction and the radial direction may also be used. Depending on the implementation however, the beams may also be oriented along specific crystallographic directions. More complex shapes can be used where the beams have an "S"-shape, (e.g. serpentine shape) or even a "U"-shape to give more flexibility for a given width and thickness.

The inventors of the present invention came to the insight that if the height of the beams (here: "Hb") is chosen at least 2 times, e.g. at least 3 times, e.g. at least 5 times larger than the width "Wb", the beams will be very rigid in the vertical direction (preventing up-down movement of the inner body), but at the same time remain quite flexible in other directions, thus allowing to absorb mechanical stress due to for example uniform (in-plane) package stress or torque. This combination makes them very interesting also for pressure sensors.

The opening 3 and the beams 7 thus form a mechanical link, while acting as a stress relief mechanism for mounting the inner part 12 to the outer part 11. It is clear that the mounting principle shown in FIG. 3 is not specifically linked to a Wheatstone bridge with piezo-resistive elements located on a circular membrane 8, but can also be used with any other pressure sensing circuit. In other words, the mechanism described above provides an on-chip flexible mechanical link between the sensitive part and the part of the chip that is mechanically connected to the housing.

FIG. 4 shows a process flow which can be used for manufacturing the device of FIG. 3, whereby the opening 3 can be filled with an anelastic material such as e.g. polyimide at wafer level or after chip singulation (dicing) at packaging level.

FIG. 4(a) illustrates the result of a first step of the process, wherein a standard base wafer is provided, and is oxidized and patterned for DRIE masking. In this step a round cavity may be formed (in the middle), and a concentric circular slit (see FIG. 3(b)). Round cavities are the most efficient use of the surface.

FIG. 4(b) illustrates the step of DRIE etching. In fact two options are shown:

- The central cavity may be a deep cavity, e.g. for producing relative pressure sensors. In this case the etching of the central cavity and the etching of the circular slit can be formed simultaneously.
- Alternatively, the central cavity may be a shallow cavity, e.g. for producing an absolute pressure sensor. In this case a two-step etch can be applied to form the central cavity (shallow) and the deep circular slit.

FIG. 4(c) shows the structure of FIG. 4(b) after oxide strip, and after fusion bonding with the thinned top wafer. The top wafer may be a thinned SOI wafer. The thickness of the top wafer defines the thickness of the membrane and the thickness of the bridges (beams). One could create cavities at the top (membrane) wafer prior to bonding which result in either a thinner membrane or a thinner beam when the cavities are defined at these places respectively. This is not shown in the drawing. Even beams or membranes with relatively thicker parts are possible which could improve the linearity of the membrane or the stiffness of the beams. In some embodiments the beams may be thicker than the membrane. In other embodiments, the membrane may be thicker then the beams. In some embodiments, the thickness of the membrane is not constant, but may e.g. be thicker in the middle and decrease away from the center, or vice versa. In some embodiments, the beams need not have a constant thickness, but the thickness may vary over the length of the beams.

Especially for capacitive sensors one can also create a cavity under the membrane by bonding an oxidised wafer to a non-oxidized wafer where the oxide of the oxidized wafer is removed in the membrane area by standard CMOS process techniques. The oxide thickness then defines the gap between the membrane and the bulk to form a pressure dependent capacitor where the membrane and the bulk form the capacitor plates. (see FIG. 8)

FIG. 4(d) shows the structure of FIG. 4(c) after formation of an exemplary piezo-resistor-structure, e.g. using a standard piezo-process, thermal oxide, LPCVD nitride, piezo, n++, p++ implants, and metallization and optional passivation steps. It will be clear to the skilled person that this step (or these steps) depend(s) on the actual sensitive structure being implemented on the membrane. As mentioned above, the present invention is not limited to any specific structure.

FIG. 4(e) shows the structure of FIG. 4(d) after etching the membrane wafer above the slit structures and filing them with an anelastic material. In this example, the bridges have the same thickness as the membrane, and the sides of the bridges are etched with an additional (dry) etching step from the front side. The slit below the bridges was already etched together with the cavity under the membrane and therefore does not require additional processing. Optionally in this step the opening may be (at least partly, e.g. completely) filled with an anelastic material. Alternatively, the opening may also be filled after the grinding step (step f). The openings through the top wafer can be wider or narrower than the slit in the cavity wafer (lower wafer). For capacitive sensors it is an advantage that the etching of the membrane is independent of the slit etching. In that way the magnitude of the capacitor can be chosen indepently from the slit etching.

Alternatively the slit opening and slit filling with soft or anelastic material could be carried out after the high temperature processing such as diffusion and LPCVD deposition but before the metallization is carried out. In that case no bridges are needed and the connection between the inner and outer parts is completely provided by the filling material. With this process the flexible beams 7 only consist of metal and passivation layers and no silicon is present under the metal. The metal and passivation layers are then deposited on top of the filling material.

FIG. 4(f) shows the structure of FIG. 4(e) after grinding and opening the membrane from the back. The slit is opened from the bottom with a grinding process that also opens the cavity for relative pressure sensors. The slit is sealed (but hermetic sealing is not required) to prevent a fluid flow through the slit. The remaining thickness is typically in the range of 600 to 200 um.

Thus, the sealing can be provided on wafer level by dispensing an anelastic material before opening the slits from the back (FIG. 4(e)), or the sealing can also be provided during the assembly process with the same gel that is used for protection of the bondwires. It is an advantage that the sealing of the opening between the inner and outer part can be done with the same anelastic gel as is used for protection of the bond wires.

Another option is to open the slits at the front side only after the back grinding that is necessary to open the slits from the bottom and the cavity for the relative pressure sensors. This has the advantage that the wafers are less fragile during grinding.

The described method is suitable for integrated pressure sensors where the CMOS processing takes place at the same processing stage as the realization of the piezo-resistors. The CMOS circuitry can be placed in the sensing area (on the inner part) and/or in the bonding area (on the outer part).

Further processing steps, such as e.g. wafer dicing and packaging, can then be applied to produce packaged pressure sensor ICs.

In variants of the method described above, the back grinding (step f) can be replaced by a plasma etch whereby only the area of the through-opening 3 and the inner part 12 are etched, but not the outer part 11. This is possible also after filling the trenches. Using etching rather than grinding offers the advantages that reduced forces are exercised on the flexible elements 7 (e.g. the beams) and that the outer part 11 is thicker than the inner part 12 (Ho > Hi) which may facilitates assembly of the sensor structure in a package (as will be described further in relation to FIG. 9 and FIG. 10).

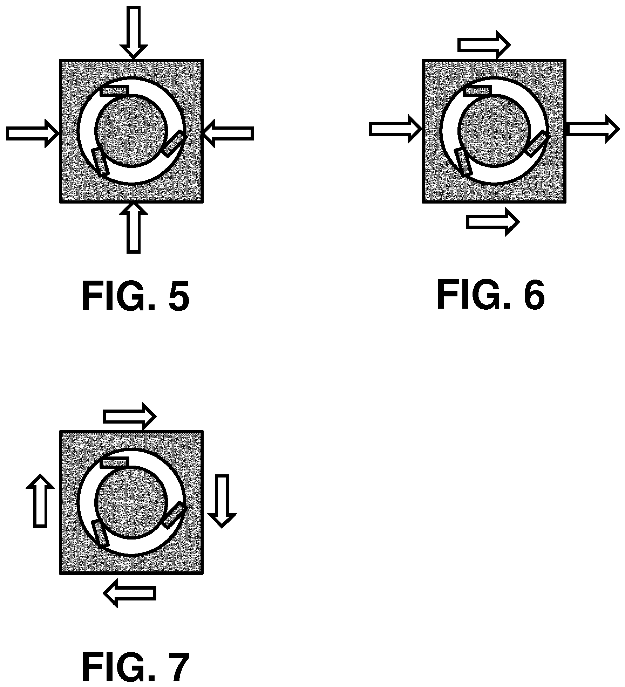

**FIG. 5** shows the pressure sensor of FIG. 3, subjected to radial stress, e.g. due to thermal compression or thermal expansion of the outer part in the presence of a temperature gradient. It will be understood by the skilled person, the radial stress will be largely absorbed by the beams and/or converted in a rotation of the inner part.

**FIG. 6** shows an embodiment of the present invention, subjected to uniform in-plane stress (in the example shown: from left to right). It will be understood by the skilled person, that this stress is not transferred to the inner part at all, since the inner part is only suspended by the beams and does not touch the housing anywhere else.

**FIG. 7** show an embodiment of the present invention, subjected to torque stress. It will be understood by the skilled person, that torque stress is not transferred to the inner part either, because the inner part can simply rotate, thereby alleviating such stress completely.

Although particular embodiments have been described, further variations are possible. For example, the inner part 12 and/or the outer part 11 may comprise further circuitry. For example if the substrate is a CMOS substrate, the inner part or the outer part or both, may contain additional circuitry, e.g. amplification circuitry, readout-circuitry, digitization circuitry, etc.

**FIG. 8** shows a pressure sensor having the same stress relief mechanism as described in FIG. 3, with an outer body 11 and an inner body 12, the inner body being movable in an opening of the outer body, and suspended therein by means of one or more, e.g. at least three flexible elements. Everything described above for the first embodiment, is also applicable here, for example, the inner body may be cylindrical, the opening may be annular, the flexible elements may be oriented tangential etc, except for the sensing elements, described next.

Whereas the sensor of FIG. 3 has a membrane upon which one or more piezo-resistive elements are mounted for measuring a deflection of the membrane caused by the external pressure to be measured, another principle is used here, namely: capacitive measurement. For known capacitive sensors the membrane is suspended over an undeep cavity and the capacitance is then the sum of the varying capacitance of the membrane area plus the static capacitance of the area around the membrane. This static capacitance reduces the sensitivity as it does not change with pressure. With the stress-relief mechanism comprising the through-opening of the present invention, such static capacitance can be greatly reduced.

Often differential measurement is applied for capacitive sensing where a second fixed capacitance without a cavity is realized in a similar way to allow differential measurement between the sensing capacitor and this second fixed capacitor, which does not change under the external pressure to be measured. Using the through-opening, a second capacitor Creference can be formed on the outer part 12 as shown in FIG. 8, which is insensitive to the applied pressure and which is matched with the inner part (same gap and same dielectric constant). By proper balancing the area of the capacitor Csense located on the inner part 12 and the capacitor Creference located on the outer part 12, the capacitances can be made equal to optimize differential measurement.

**FIG. 9** and **FIG. 10** are two examples to illustrate that the pressure sensor with the stress relief structure of the present invention is particularly suitable for overmoulded packages where the sensor (outer body 11) is mounted over a hole in the lead-frame 18, which hole has dimensions (e.g. a diameter) equal to or preferably larger than the outer diameter of the through-opening 3 of the sensor, to allow the inner body 12 to move relative of the lead frame 18, but smaller than the outer dimensions of the outer part 11 for holding the outer part 11.

Using film assisted moulding and a proper mould shape one can realize openings above and below the sensor structure 1 and make sure that the mould is only attached to the outer part 11 thereof. The bond wires 19 can be encapsulated in the mould compound. The anelastic material between the outer and inner part can be applied after the moulding with standard dispensing tools commonly used for assembly. FIG. 9 is an example of a QFN package, FIG. 10 is an example of a SOIC package.

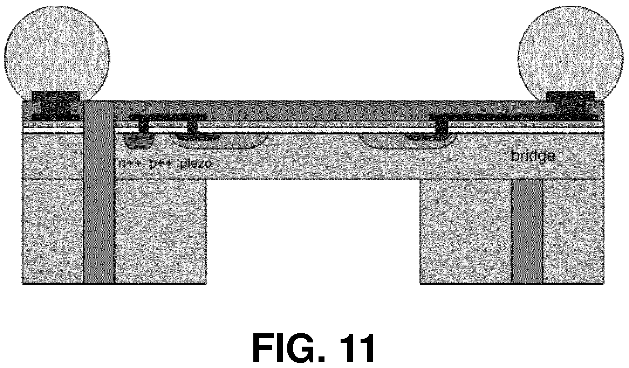

FIG. 11 shows an example to illustrate that the stress relief structure can be used for pressure sensors that are mounted by Flip-Chip soldering. The stress introduced by the rigid solder connection is absorbed by the beams and anelastic material. The placement of solder bumps can be carried out after the filling of the slits and thinning of the backside of the wafers.

REFERENCES

| 1 | pressure sensor | 2 | substrate |
|---|---|---|---|
| 3 | through-opening | 4 | top surface |
| 5 | bottom surface | 7 | beams |
| 8 | membrane | 9 | piezo-resistive elements |
| 10 | groove | 11 | outer part |
| 12 | inner part | 13 | electrical interconnection |
| 14 | bond pad | 15 | cavity |
| 17 | anelastic material | 18 | lead frame |
| 19 | bond wire | X | direction of beams |
| Tm | thickness of membrane | Tb | thickness of beam |
| c | center of membrane | | |

**Claims**

1. A semiconductor pressure sensor (1) for measuring a pressure, comprising:

   - a semiconductor substrate (2) having a through-opening (3) extending from a top surface (4) to a bottom surface (5) of the substrate (2), the through-opening (3) forming a hollow space between an inner part (12) and an outer part (11) of said substrate;
   - a pressure responsive structure arranged on said inner part (12);
   - a number of flexible elements (7, 13) extending from said inner part (12) to said outer part (11) for suspending the inner part (12) within said through-opening (3);
   - the through-opening being sealed with an anelastic material.

2. The semiconductor pressure sensor (1) according to claim 1,

   - wherein the pressure responsive structure (6) comprises a membrane (8) arranged for deforming under the pressure to be measured, and one or more elements for allowing measurement of said deformation;
   - and optionally wherein the one or more elements are piezo-resistive elements (9).

3. The semiconductor pressure sensor (1) according to any of the previous claims,

   - wherein the through-opening (3) is or comprises a groove (10) extending in a direction perpendicular to the substrate (2);
   - and optionally wherein the through-opening (3) has a circular cross section in a plane parallel to the substrate.

4. The semiconductor pressure sensor (1) according to any of the previous claims,

   - wherein the flexible elements are beams (7);
   - and optionally wherein the beams have a length (Lb) and a width (Wb) and a height (Hb), whereby the height (Hb) is at least 2.0 times the width (Wb);
   - and optionally wherein the beams (7) extend across the through-opening in a non-radial direction (X);
   - and optionally wherein the beams (7) are tangential to a circumference of the inner part (12);
   - and optionally wherein the beams (7) are parallel to the substrate and wherein a thickness (Tm) of the membrane and a thickness (Tb) of beam are substantially the same;
   - and optionally wherein the number of beams (7) is a value in the range from 3 to 32, preferably in the range from 3 to 4.

5. The semiconductor pressure sensor (1) according to any of the claims 1 to 3,

- wherein the flexible elements are formed by applying a metallization that extends accross the through-opening on top of the anelastic material.

6. Method of producing a semiconductor pressure sensor (1), comprising the steps of:

a) providing a substrate;
b) making a through-opening (3) extending from a top surface (4) to a bottom surface (5) of said substrate along a closed curve, said through-opening forming a hollow space between an inner part (12) and an outer part (11) of said substrate;
b) forming a pressure responsive structure on said inner part (12);
c) sealing the through-opening (3) with an anelastic material;
d) providing a number of flexible elements (7, 13) extending from said inner part (12) to said outer part (11) for suspending the inner part within said through-opening (3).

7. The method according to claim 6,

- wherein the step of forming a pressure responsive structure on said inner part comprises forming a membrane and forming pressure sensitive elements located at least partly on the membrane;
- and optionally wherein forming the pressure sensitive elements comprises forming piezo-resistive elements (9);
- and optionally wherein the step of forming a through-opening comprises forming a groove (10) extending in a direction perpendicular to the substrate (2);
- and optionally wherein the step of making a through-opening comprises making an annular opening.

8. The method according to claim 6 or 7,

- wherein the step of providing flexible elements (7, 13) comprises forming flexible beams extending from the inner part (12) to the outer part (11);
- and optionally wherein the flexible beams are formed in such a way that the beams are straight and extend in a non-radial direction;
- and optionally wherein the flexible beams are formed in such a way that the beams are tangential to a circumference of the inner part (12).

9. The method according to claim 8, wherein the beams (7) and the membrane are formed such that the beams (7) are parallel to the substrate and such that a thickness (Hm) of the membrane and a thickness (Hb) of the beams is substantially the same.

10. The method according to claim 6 or 7, wherein the step of providing flexible elements (7, 13) comprises applying a metallization directly on top of the anelastic material.

11. The method according to claim 9 or 10,

- further comprising a step of grinding the substrate;
- and wherein the step of sealing the through-opening with an anelastic material occurs either before the step of grinding the substrate and before the step of metallization or before the step of grinding the substrate but after the step of metallization.

12. The method according to any of the claims 6 to 11, further comprising a step of grinding the substrate, and wherein the step of sealing the through-opening with an anelastic material occurs after the step of grinding the substrate.

13. The method according to claim 9 or 10, and one of the following alternatives:

a) further comprising a step of simultaneously back etching the outer part (11) and the inner part (12), and wherein the step of sealing the through-opening with an anelastic material occurs before the step of metallization;
b) further comprising a step of simultaneously back etching the outer part (11) and the inner part (12), and wherein the step of sealing the through-opening with an anelastic material occurs before the step of back etching but after the step of metallization;
c) further comprising a step of back etching the inner part (12) but not the outer part (11), and wherein the step of sealing the through-opening with an anelastic material occurs before the step of metallization;

d) further comprising a step of back etching the inner part (12) but not the outer part (11), and wherein the step of sealing the through-opening with an anelastic material occurs before the step of back etching but after the step of metallization.

14. The method according to any of the claims 6 to 10, further comprising a step of simultaneously back etching the the outer part (11) and the inner part (12), and wherein the step of sealing the through-opening with an anelastic material occurs after the step of back etching.

15. The method according to any of the claims 6 to 10, further comprising a step of back etching the inner part (12) but not the outer part (11), and wherein the step of sealing the through-opening with an anelastic material occurs after the step of back etching.

V groove

**FIG 1 (prior art)**

n++  p++  piezo    bridge

8

3

1

**FIG 2**

FIG 3

FIG 4

**FIG. 5**

**FIG. 6**

**FIG. 7**

Creference

Csense

Grinding to 400 μm
Opening membrane
from the back

**FIG. 8**

QFN package

**FIG. 9**

SIOC package

11

18

19

**FIG. 10**

n++ p++ piezo

bridge

# FIG. 11

Europäisches
Patentamt

European
Patent Office

Office européen
des brevets

# EUROPEAN SEARCH REPORT

**Application Number**

EP 18 16 6696

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2014/001584 A1 (LIU LIANJUN [CN]) 2 January 2014 (2014-01-02) * abstract; figure 1 * * paragraph [0108]; claim 12 * ----- | 1-15 | INV. G01L9/00 |
| A | WO 2010/106473 A1 (NXP BV [NL]; HOCHSTENBACH HENDRIK PIETER [NL]; DRIEL WILLEM DIRK [NL];) 23 September 2010 (2010-09-23) * abstract; figures 1,2 * * page 5, lines 10-24 * * page 20, lines 5-17 * ----- | 1-15 | |

**TECHNICAL FIELDS
SEARCHED (IPC)**

G01L

The present search report has been drawn up for all claims

| Place of search | Date of completion of the search | Examiner |
|---|---|---|
| The Hague | 29 May 2018 | Mihai Vasile |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 18 16 6696

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2018

| Patent document cited in search report | Publication date | Patent family member(s) | Publication date |
|---|---|---|---|
| US 2014001584 A1 | 02-01-2014 | CN 102156012 A<br>US 2014001584 A1<br>WO 2012122875 A1 | 17-08-2011<br>02-01-2014<br>20-09-2012 |
| WO 2010106473 A1 | 23-09-2010 | NONE | |

EPO FORM P0459

For more details about this annex : see Official Journal of the European Patent Office, No. 12/82